# EUROPÄISCHE PATENTSCHRIFT

(11) **EP 1 840 961 B1**
(45) Veröffentlichungstag und Bekanntmachung des Hinweises auf die Patenterteilung: **09.04.2014**
(21) Anmeldenummer: 07002024.3
(22) Anmeldetag: 31.01.2007
(51) Int. Cl.: H01L 23/00, H05K 7/14, H01L 25/07

(54) **Leistungshalbleitermodul**
Power semiconductor module
Module semi-conducteur de puissance

(30) Priorität: 13.02.2006 DE 102006006421
(43) Veröffentlichungstag der Anmeldung: 03.10.2007
(73) Patentinhaber: SEMIKRON Elektronik GmbH & Co. KG, 90431 Nürnberg (DE)
(72) Erfinder: Lederer, Marco, 90453 Nürnberg (DE); Popp, Rainer, 91580 Petersaurach (DE)

(56) Entgegenhaltungen:
- EP-A- 0 513 410
- DE-A1- 4 237 632
- DE-A1- 19 719 703
- DE-A1-102004 025 609
- US-A- 5 425 649

## Beschreibung

Die Erfindung beschreibt ein Leistungshalbleitermodul in Druckkontaktausführung sowie ein zugehöriges Herstellungsverfahren. Einen Ausgangspunkt der Erfindung bilden Leistungshalbleitermodule wie sie beispielhaft aus der DE 197 19 703 A1 und aus der EP 0 513 410 A1 bekannt sind.

Derartige Leistungshalbleitermodule bestehen nach dem Stand der Technik aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weisen die bekannten Leistungshalbleitermodule Anschlusselemente für externe Last- und Hilfsanschlüsse sowie im Inneren angeordnete Verbindungselemente auf. Diese Verbindungselemente für schaltungsgerechte Verbindungen im Inneren des Leistungshalbleitermoduls sind meist als Drahtbondverbindungen ausgebildet.

Ebenfalls bekannt sind druckkontaktierte Leistungshalbleitermodule, wie sie aus der DE 42 37 632 A1 bekannt sind. In dieser Druckschrift weist die Druckeinrichtung ein stabiles, vorzugsweise metallisches, Druckelement zum Druckaufbau, ein elastisches Kissenelement zur Druck Speicherung und ein Brückenelement zur Druckeinleitung auf gesonderte Bereiche der Substratoberfläche auf. Das Brückenelement ist vorzugsweise ausgestaltet als ein Kunststoffformkörper mit einer dem Kissenelement zugewandten Fläche, von der eine Vielzahl von Druckfingern in Richtung der Substratoberfläche ausgehen.

Mittels einer derartigen Druckeinrichtung wird das Substrat auf ein Kühlbauteil gedrückt und somit der Wärmeübergang zwischen dem Substrat und dem Kühlbauteil dauerhaft sicher hergestellt. Das elastische Kissenelement dient hierbei der Aufrechterhaltung konstanter Druckverhältnisse bei unterschiedlichen thermischen Belastungen und über den gesamten Lebenszyklus des Leistungshalbleitermoduls.

Aus der DE 10 2004 025 609 A1 ist ein Leistungshalbleitermodul mit einer Grundplatte und als Kontaktfedern ausgebildete Hilfsanschlusselementen bekannt. Gemäß dieser Druckschrift werden die Kontaktfedern zur sicheren elektrischen Kontaktierung mittels eines Deckels mit Druck beaufschlagt. Hierbei sind die Kontaktfedern in einer nicht detailliert offen gelegten Halterung des Gehäuses angeordnet.

Der Erfindung liegt die Aufgabe zugrunde ein Leistungshalbleitermodul vorzustellen wobei die Anschlusselementen federnd ausgebildeten sind, gegen Herausfallen sowie gegen Verdrehen gesichert sind und das Leistungshalbleitermodul einer einfachen Herstellung zugänglich ist.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einer Anordnung eines Leistungshalbleitermoduls, vorzugsweise in Druckkontaktausführung zur Anordnung auf einem Kühlbauteil, mit mindestens einem Substrat, mindestens einem hierauf angeordneten steuerbaren Leistungshalbleiterbauelement, einem Gehäuse und nach außen führenden Last- und Hilfsanschlusselementen, wobei der Begriff Hilfsanschlusselemente auch Steueranschlüsse, wie beispielhaft Gateanschlüsse von IGBTs (insulated gate bipolar transistor) einschließt. Die Leistungshalbleiterbauelemente sind hierbei auf zueinander isoliert angeordnete Leiterbahnen des Substrats angeordnet und schaltungsgerecht verbunden.

Mindestens ein Anschlusselement ist als eine Kontaktfeder mit einer ersten Kontakteinrichtung, mindestens einem federnden Abschnitt und einer zweiten Kontakteinrichtung ausgebildet. Das erfindungsgemäße Leistungshalbleitermodul weist weiterhin einen ersten und einen zweiten Kunststoffformkörper auf, wobei der erste Kunststoffformkörper mindestens einen senkrecht zum Substrat angeordneten Schacht zur Aufnahme eines Anschlusselements aufweist. Dieser Schacht weist eine seitliche Ausnehmung zur verdrehsicheren Anordnung des Anschlusselements sowie eine Aussparung für einen zugeordneten Teilkörper des zweiten Kunststoffformkörper auf. Dieser Teilkörper weist ebenfalls eine seitliche Ausnehmung und auf der dem Substrat abgewandten Seite eine parallel hierzu verlaufende Ausnehmung für die erste Kontakteinrichtung des Anschlusselements auf, wobei diese Kontakteinrichtung durch diese Ausnehmung hindurch reicht.

Die erfinderische Lösung wird an Hand der Ausführungsbeispiele der Fig. 1 bis 5 weiter erläutert.

Fig. 1 zeigt einen Schnitt durch ein Leistungshalbleitermodul gemäß dem Stand der Technik.

Fig. 2 zeigte ein Anschlusselement eines erfindungsgemäßen Leistungshalbleitermoduls.

Fig. 3 zeigt einen Schnitt durch eine Anordnung eines Anschlusselements des erfindungsgemäßen Leistungshalbleitermoduls.

Fig. 4 zeigt in dreidimensionaler Explosionsdarstellung einen Schnitt durch ein erfindungsgemäßes Leistungshalbleitermodul.

Fig. 5 zeigt in dreidimensionaler Darstellung einen detaillierten Ausschnitt aus einem erfindungsgemäßen Leistungshalbleitermodul.

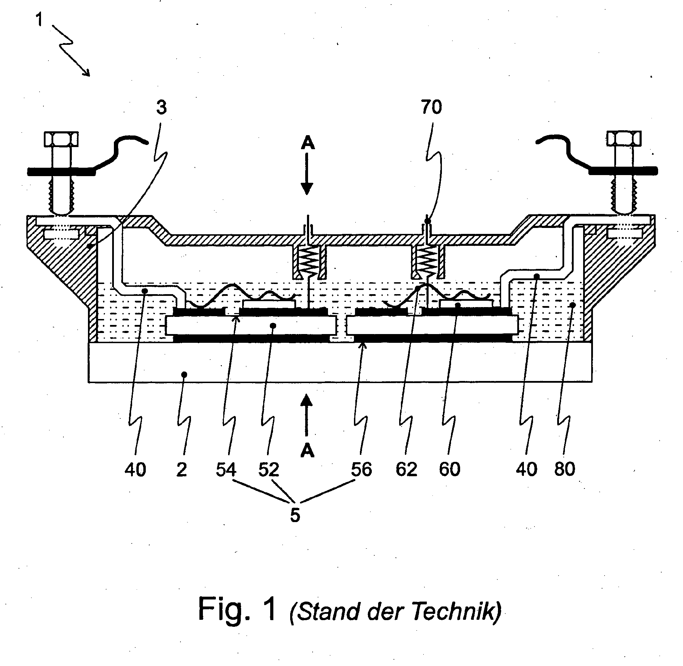

Fig. 1 zeigt ein Leistungshalbleitermodul (1) nach dem Stand der Technik mit einer Grundplatte (2) im Längsschnitt. Auf dieser Grundplatte (2) angeordnet sind ein rahmenartige Gehäuse (3) sowie zwei Substrate (5). Jedes Substrat (5) besteht aus einem Isolierstoffkörper (52) sowie aus metallischen Kaschierungen, die auf beiden Hauptflächen angeordnet sind. Die der Grundplatte (2) zugewandte metallische Kaschierung (56) ist flächig ausgebildet und in sich nicht strukturiert. Mittels einer Lötverbindung zwischen dieser Kaschierung (56) und der Grundplatte (2) werden diese zueinander fixiert. Demgegenüber ist die dem Inneren des Leistungshalbleitermoduls (1) zugewandte Kaschierung in sich strukturiert und bildet somit die Leiterbahnen (54) des Substrats (5) aus.

Auf diesen Leiterbahnen (54) sind die Leistungshalbleiterbauelemente (60) angeordnet. Die Leistungs- (40) und die Hilfsanschlüsse (70) bilden die elektrischen Anschlusselemente des Leistungshalbleitermoduls (1). Die Hilfsanschlüsse (70) sind als Kontaktfedern ausgebildet und bedürfen im Betrieb einer Druckbeaufschlagung zur sicheren elektrischen Kontaktierung. Die schaltungsgerechte Verbindung der Leistungshalbleiterbauelemente (60) mit den Leiterbahnen (54) ist als Drahtbondverbindung (62) ausgebildet.

Die Anschlusselemente (40) der Leistungsanschlüsse werden gebildet durch Metallformkörper, die an ihrem einen Ende löttechnisch mit der zugeordneten Leiterbahn (54) des Substrats (5) verbunden sind und an ihrem anderen Ende eine Ausnehmung zur Schraubverbindung aufweisen.

Das Gehäuse (3) des Leistungshalbleitermoduls (1) ist zweistückig ausgebildet. Ein erster rahmenartiger Teil des Gehäuses (3) umschließt die Substrate (5), während ein zweiter Teil den Deckel des Gehäuses (3) bildet. Dieser Deckel weist Ausformungen zur Positionierung und Fixierung der Hilfsanschlüsse (70) auf. Die Leistungsanschlüsse (40) werden jeweils in dem rahmenartigen Gehäuseteil fixiert. Das Leistungshalbleitermodul (1) ist zur inneren elektrischen Isolierung mit einem Silikongel (80) vergossen.

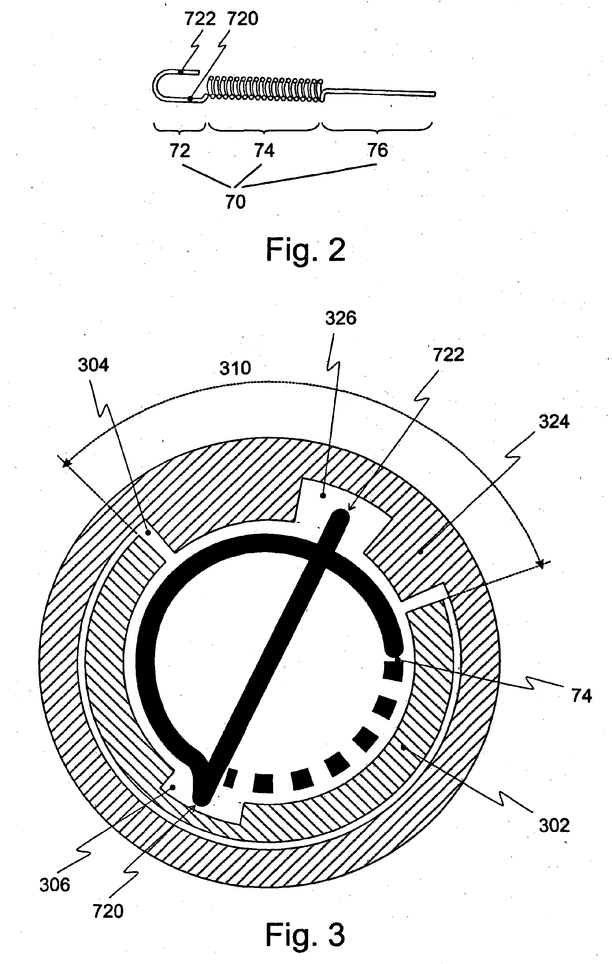

Fig. 2 zeigt ein Anschlusselement (70) eines erfindungsgemäßen Leistungshalbleitermoduls (1). Das Anschlusselement ist als Kontaktfeder (70) mit einem einer ersten (72) und einer zweiten Kontakteinrichtung (76) ausgebildet. Zwischen beiden Kontakteinrichtungen (72, 76) ist der federnde Abschnitt (74), hier in bevorzugter Weise als Schraubenfeder ausgebildet, des Anschlusselements (70) angeordnet.

Die erste Kontakteinrichtung (72) des Anschlusselements (70) ist bügelförmig ausgebildet und weist zwei seitliche Längsabschnitte (720, 722) auf. Diese Längsabschnitte überragen den federnden mittleren Abschnitt (74) in seinem Durchmesser (vgl. Fig. 3). Diese bügelförmige Kontakteinrichtung (72) ist besonders vorteilhaft zur Kontaktierung von Leiterbahnabschnitten auf Leiterplatten nach dem Stand der Technik, da hierbei die Oberfläche des Leiterbahnabschnitts durch die Kontakteinrichtung nicht beschädigt wird. Diese Ausgestaltung eines Anschlusselements (70) ist besonders bevorzugt, allerdings nicht beschränkt auf die Kontaktierung von Hilfsanschlüssen.

Die zweite Kontakteinrichtung (76) ist stiftartig ausgebildet, da diese Kontakteinrichtung (76) bevorzugt Leiterbahnen (54) des Substrats (5) kontaktiert. Diese Leiterbahnen (54) weisen eine deutlich größere Schichtdicke im Vergleich zu denjenigen von Leiterplatten auf, wodurch auch hier ein dauerhaft sicherer elektrischer Kontakt erreicht wird.

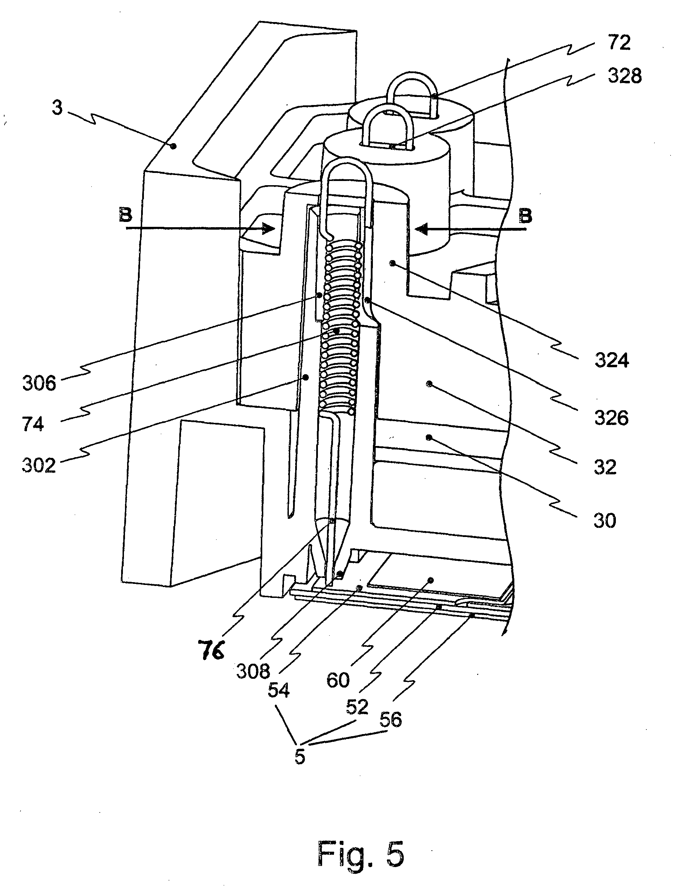

Fig. 3 zeigt einen Schnitt durch eine Anordnung eines Anschlusselements des erfindungsgemäßen Leistungshalbleitermoduls (vgl. Schnitt B-B in Fig. 5). Dargestellt ist als Teil eines ersten Kunststoffformkörpers (30) ein senkrecht zum Substrat (5) angeordneter Schacht (302). In diesem Schacht (302) ist ein Anschlusselement (70) angeordnet, wobei dessen federnder Abschnitt (74) und auch dessen erste Kontakteinrichtung (72) dargestellt sind. Zur Aufnahme eines Längsabschnitts (722) dieser ersten Kontakteinrichtung (72) weist der Schacht (302) eine seitliche Ausnehmung (306) auf. Mittels dieser Ausnehmung ist das Anschlusselement (70) bereits verdrehsicher im Schacht angeordnet. Weiterhin weist der Schacht (302) eine Aussparung (304) auf.

Diese Aussparung (304) dient der Aufnahme eines zugeordneten Teilkörper (324) eines zweiten Kunststoffformkörper (32). Hierbei ist die Öffnung dieser Aussparung (304) vorteilhafterweise auf einen Öffnungswinkel (310) von weniger als 180 Grad begrenzt. Besonders vorteilhaft für den Herstellungsprozess des Leistungshalbleitermoduls (1) ist es den Öffnungswinkel (310) dieser Aussparung (304) derart auszuführen, dass ein seitliches Herauskippen des Anschlusselements (70) nicht möglich ist.

Der Teilkörper (324) des zweiten Kunststoffformkörper (32), der innerhalb der Aussparung (304) des Schachts (302) angeordnet ist und zusammen mit diesem eine geeignet ausgeformte Aufnahmen des Anschlusselements (70) bildet, weist ebenfalls eine seitliche Ausnehmung (326) auf. Diese dient ebenso wie diejenige (306) des Schachts (302) zur verdrehsicheren Ausbildung der Anordnung des Anschlusselements (70) in dieser Aufnahme.

Das Anschlusselement (70) ist verdrehsicher in der durch den Schacht (302) und den Teilkörper (324) gebildeten Aufnahme angeordnet, da die erste Kontakteinrichtung (72) des Anschlusselements (70) bügelförmig ausgebildet ist und zwei seitliche Längsabschnitte (720, 722) aufweist, die den federnden Abschnitt (74) in seinem Durchmesser überragen.

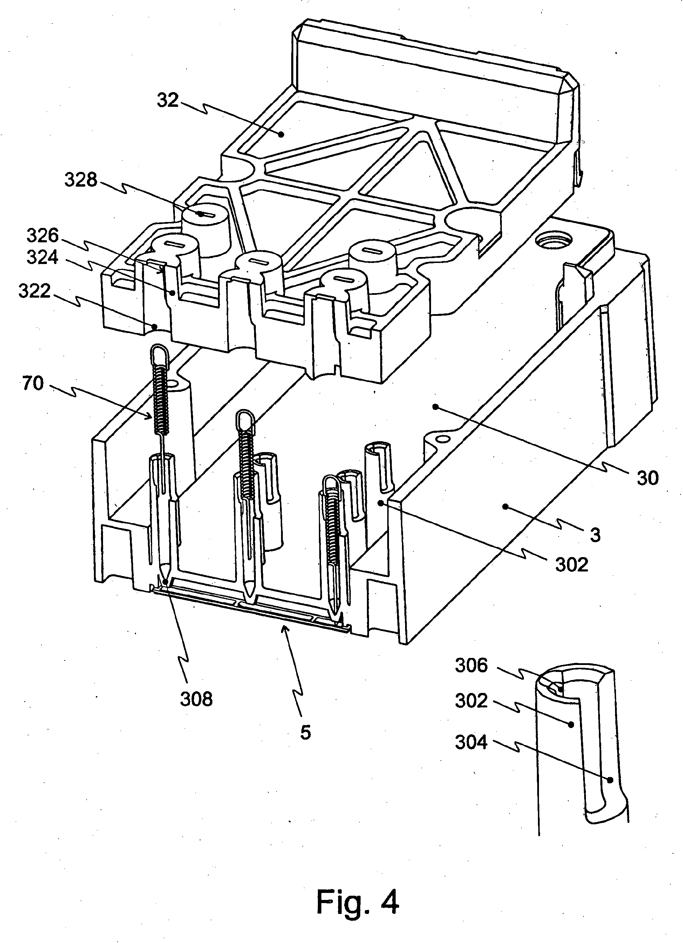

Fig. 4 zeigt in dreidimensionaler Explosionsdarstellung einen Schnitt, vergleichbar der Schnittlinie A-A der Fig. 1, durch ein erfindungsgemäßes Leistungshalbleitermodul (1). Dargestellt ist das durch das Gehäuse (3) umschlossene Substrat (5), hierüber angeordnet ein erster Kunststoffformkörper (30), der hier in bevorzugter Weise einstückig mit dem Gehäuse (3) ausgebildet ist. Der Kunststoffformkörper (30) weist eine Mehrzahl von Schächten (302) auf, in den die Anschlusselement (70) hier Hilfsanschlusselemente angeordnet sind. Hierbei befindet sich ein Längsabschnitt (720, vgl. Fig. 2 oder 3) der ersten Kontakteinrichtung (72) des Anschlusselements (70) in einer Ausnehmungen (306) dieses Schachts (302).

Der dem Substrat (5) abgewandte Abschnitt eines Schachts (302) ist zusätzlich nochmals vergrößert dargestellt. Hierbei ist die Ausnehmung (306) zur Anordnung eines Längsabschnitts (720) einer bügelförmig ausgebildeten ersten Kontakteinrichtung (72) des Anschlusselements (70) ebenso wie die Aussparung (306) zur Anordnung eines Teilkörpers (324) eines zweiten Kunststoffformkörpers (32) mit einer Ausnehmung (322) dargestellt. Weiterhin ist eine Phase am Rand des Schachts (302) zur vereinfachten Herstellung der Anordnung aus Schacht (302) und Anschlusselement (70) erkennbar.

Das dargestellte Leistungshalbleitermodul (1) ist in Druckkontaktausführung ausgebildet, wobei der zweite Kunststoffformkörper (32) vorteilhafterweise einen Teil der Druckeinrichtung ausbildet. Diejenigen Bereiche des zweiten Kunststoffformkörpers (32), die den Teilkörper (324) ausbilden weisen ebenfalls Ausnehmungen (326) zur Aufnahme von Längsabschnitten (722) der bügelförmig ausgebildeten ersten Kontakteinrichtung (72) des Anschlusselements (70) auf. Weiterhin weist der zweite Kunststoffformkörper (32) mit dem Schacht (302) des ersten Kunststoffformkörpers (30) fluchtende Ausnehmungen (328) auf, durch welche die jeweils erste Kontakteinrichtung (72) der Anschlusselemente (70) hindurch reichen. Die jeweilige Ausnehmung (328) ist derart gestaltet, dass nur die erste Kontakteinrichtung (72) nicht aber der federnde Abschnitt (74) hindurch reicht, wodurch das gesamte Anschlusselement (70) gegen herausfallen aus dem fertig montierten Leistungshalbleitermodul (1) gesichert ist.

Auf der dem Substrat (5) zugewandten Seite des ersten Kunststoffformkörpers (30) weist der Schacht (302) zur Aufnahme des federnden Abschnitts (74) des Anschlusselements (70) mit diesem fluchtend eine Durchführung (308) zur Kontaktierung der zweiten Kontakteinrichtung (76) mit Leiterbahnen (54) des Substrats (5), oder auch direkt mit einem auf dem Substrat angeordneten Leistungshalbleiterbauelement auf.

Fig. 5 zeigt in dreidimensionaler Darstellung einen detaillierten Ausschnitt aus einem erfindungsgemäßen Leistungshalbleitermodul (1) gemäß Fig. 4. Das Gehäuse (3) ist wiederum einstückig mit dem ersten Kunststoffformkörper (30) ausgebildet und umschließt das Substrat (5). Dieses weist einen Isolierstoffkörper (52) und zwei Metallkaschierungen, eine unstrukturierte (56) auf der Inneren des Leistungshalbleitermoduls (1) abgewandten Seite, sowie ein strukturierte und damit Leiterbahnen (54) ausbildende auf der dem Inneren des Leistungshalbleitermoduls (1) zugewandten Seite, auf. Auf einer Leiterbahn (54) ist ein Leistungshalbleiterbauelement (60) angedeutet, wobei alle schaltungsgerechten internen Verbindungen aus Gründen der Übersichtlichkeit nicht dargestellt sind.

Ein Anschlusselement (70) kontaktiert mit seiner zweiten Kontakteinrichtung (76) eine der Leiterbahnen (54) des Substrats (5). Hierzu ist das Anschlusselement (70) in einem Schacht (302) eines ersten Kunststoffformkörpers (30) angeordnet, wobei dieser substratseitig eine als Führung für die zweite Kontakteinrichtung (76) ausgebildete Durchführung (308) aufweist.

Der federnde Abschnitt (74) des Anschlusselements (70) ist in einer Aufnahme, die gebildet ist aus dem Schacht (302) des ersten Kunststoffformkörpers (30) und dem Teilkörper (324) des zweiten Kunststoffformkörpers (32), vgl. Fig. 3. Diese Aufnahme weist in einem dem Substrat (5) abgewandten Abschnitt Ausnehmungen (306, 326) auf in den die Längsabschnitte (720, 722) der ersten Kontakteinrichtung (72) des Anschlusselements (70) angeordnet sind.

Der zweite Kunststoffformkörper (32) weist Durchführungen (328) für die ersten Kontakteinrichtungen (72) der Anschlusselemente (70) auf. Durch die beschriebene Ausgestaltung und Anordnung der beiden Kunststoffformkörper (30, 32) zueinander ist das jeweilige Anschlusselement (70) verdrehsicher und gegen herausfallen gesichert im Leistungshalbleitermodul (1) angeordnet.

## Patentansprüche

1. Leistungshalbleitermodul (1) mit mindestens einem Substrat (5), mindestens einem hierauf angeordnete Leistungshalbleiterbauelement (60), einem Gehäuse (3), einem ersten Kunststoffformkörper (30), nach außen führenden Anschlusselementen (40, 70) und einem zweiten Kunststoffformkörper (32),
wobei das Substrat (5) einen Isolierstoffkörper (52) aufweist und auf dessen erster dem Inneren des Leistungshalbleitermoduls (1) zugewandten Hauptfläche Leiterbahnen (54) angeordnet sind und
wobei mindestens ein Anschlusselement (70) als eine Kontaktfeder mit einer ersten Kontakteinrichtung (72), mindestens einem federnden Abschnitt (74) und einer zweiten Kontakteinrichtung (76) ausgebildet ist,
wobei der erste Kunststoffformkörper (30) mindestens einen senkrecht zum Substrat angeordneten Schacht (302) zur Aufnahme eines Anschlusselements (70) aufweist, dieser Schacht (302) eine seitliche Ausnehmung (306) zur verdrehsicheren Anordnung des Anschlusselements (70) und eine Aussparung (304) für einen zugeordneten Teilkörper des zweiten Kunststoffformkörper (32) aufweist, wobei dieser Teilkörper ebenfalls eine seitliche Ausnehmung (326) und auf der dem Substrat abgewandten Seite eine Ausnehmung (308) für die erste Kontakteinrichtung (72) des Anschlusselements (70) aufweist und diese hier hindurch reicht und wobei die erste Kontakteinrichtung (72) des Anschlusselements (70) bügelförmig ausgebildet ist und zwei seitliche Längsabschnitte (720, 722) aufweist, die den federnden Abschnitt (74) in seinem Durchmesser überragen.

2. Leistungshalbleitermodul nach Anspruch 1
wobei der Kunststoffformkörper (30) einstückig mit dem Gehäuse (3) ausgebildet ist.

3. Leistungshalbleitermodul nach Anspruch 1,
wobei das Leistungshalbleitermodul (1) in Druckkontaktausführung ausgebildet ist und der zweite Kunststoffformkörper (32) als ein Teil der Druckeinrichtung ausgebildet ist.

4. Leistungshalbleitermodul nach Anspruch 4,
wobei die Längsabschnitte (720, 722) der ersten Kontakteinrichtung (72) des Anschlusselements (70) in den Ausnehmungen (306, 326) angeordnet sind.

5. Leistungshalbleitermodul nach Anspruch 1,
wobei der Schacht (302) substratseitig eine als Führung für die zweite Kontakteinrichtung (76) des Anschlusselements (70) ausgebildete Durchführung (308) aufweist.

## Claims

1. A power semiconductor module (1) with at least one substrate (5), at least one power semiconductor component (60) arranged thereon, a housing (3), a first plastic moulding (30), outwardly leading connection components (40, 70) and a second plastic moulding (32),
wherein the substrate (5) has an insulating body (52) and conductor tracks (54) are arranged on the first main surface thereof which faces the interior of the power semiconductor module (1) and
wherein at least one connection component (70) is constructed as a contact spring with a first contact apparatus (72), at least one resilient section (74) and a second contact apparatus (76),
wherein the first plastic moulding (30) has at least one shaft (302) arranged perpendicularly to the substrate for accommodating a connection component (70), this shaft (302) has a lateral recess (306) for the rotationally secured arrangement of the connection component (70) and a cavity (304) for an associated part body of the second plastic moulding (32), wherein this part body likewise has a lateral recess (326) and a recess (308) for the first contact apparatus (72) of the connection component (70) on the side facing away from the substrate and the same reaches through here and wherein the first contact apparatus (72) of the connection component (70) is constructed in a bow-shaped manner and has two lateral longitudinal sections (720, 722), which project beyond the resilient section (74) in terms of the diameter thereof.

2. The power semiconductor module according to claim 1,
wherein the plastic moulding (30) is constructed in one piece with the housing (3).

3. The power semiconductor module according to claim 1,
wherein the power semiconductor module (1) is constructed in a pressure-contact design and the second plastic moulding (32) is constructed as a part of the pressure apparatus.

4. The power semiconductor module according to claim 4,
wherein the longitudinal sections (720, 722) of the first contact apparatus (72) of the connection component (70) are arranged in the recesses (306, 326).

5. The power semiconductor module according to claim 1,
wherein the shaft (302) has a passage (308) on the substrate side, which is constructed as a guide for the second contact apparatus (76) of the connection component (70).

## Revendications

1. Module semi-conducteur de puissance (1) comportant au moins un substrat (5), au moins un composant semi-conducteur de puissance (60) disposé sur celui-ci, un boîtier (3), un premier corps moulé en matière synthétique (30), des éléments de connexion (40, 70) allant vers l'extérieur et un deuxième corps moulé en matière synthétique (32),
le substrat (5) comportant un corps en matériau isolant (52) et des pistes conductrices (54) étant disposées sur la première surface principale de celui-ci opposée à l'intérieur du module semi-conducteur de puissance (1), et
au moins un élément de connexion (70) étant réalisé comme ressort de contact avec un premier dispositif de contact (72), au moins un segment élastique (74) et un deuxième dispositif de contact (76),
le premier corps moulé en matière synthétique (30) comportant au moins une cheminée (302) perpendiculaire au substrat pour le logement d'un élément de connexion (70), ladite cheminée (302) présentant un évidement latéral (306) pour la disposition avec blocage de rotation de l'élément de connexion (70) et une échancrure (304) pour une partie de corps correspondante du deuxième corps moulé en matière synthétique (32), ladite partie de corps présentant également un évidement latéral (326) et un évidement (308) sur le côté distant du substrat pour le premier dispositif de contact (72) de l'élément de connexion (70), que celui-ci atteint en étant inséré,
et le premier dispositif de contact (72) de l'élément de connexion (70) étant réalisé en forme d'étrier et présentant deux segments oblongs latéraux (720, 722) dépassant du diamètre du segment élastique (74).

2. Module semi-conducteur de puissance selon la revendication 1,
où le corps moulé en matière synthétique (30) est réalisé d'un seul tenant avec le boîtier (3).

3. Module semi-conducteur de puissance selon la revendication 1,
où ledit module semi-conducteur de puissance (1) est réalisé avec un contact par pression, et où le deuxième corps moulé en matière synthétique (32) est réalisé comme une partie du dispositif de pression.

4. Module semi-conducteur de puissance selon la revendication 4,
où les segments oblongs latéraux (720, 722) du premier dispositif de contact (72) de l'élément de connexion (70) sont disposés dans les évidements (306, 326).

5. Module semi-conducteur de puissance selon la revendication 1,
où la cheminée (302) présente côté substrat une traversée (308) réalisée comme guidage pour le deuxième dispositif de contact (76) de l'élément de connexion (70).
